# EUROPÄISCHE PATENTSCHRIFT

(11) **EP 2 108 052 B1**
(45) Veröffentlichungstag und Bekanntmachung des Hinweises auf die Patenterteilung: **12.10.2011**
(21) Anmeldenummer: 07817786.2
(22) Anmeldetag: 07.11.2007
(51) Int. Cl.: C23C 14/00, C23C 14/06, C23C 14/35, H01L 31/032

(54) **REAKTIVES MAGNETRON-SPUTTERN ZUR GROSSFLÄCHIGEN ABSCHEIDUNG VON CHALKOPYRIT-ABSORBERSCHICHTEN FÜR DÜNNSCHICHTSOLARZELLEN**
REACTIVE MAGNETRON SPUTTERING FOR THE LARGE-SCALE DEPOSITION OF CHALCOPYRITE ABSORBER LAYERS FOR THIN LAYER SOLAR CELLS
PULVÉRISATION MAGNÉTRON RÉACTIVE POUR DÉPÔT À GRANDE ÉCHELLE DE COUCHES ABSORBANTES DE CHALCOPYRITE POUR CELLULES SOLAIRES À COUCHES MINCES

(30) Priorität: 29.11.2006 DE 102006057068
(43) Veröffentlichungstag der Anmeldung: 14.10.2009
(73) Patentinhaber: Helmholtz-Zentrum Berlin für Materialien und Energie GmbH, 14109 Berlin (DE)
(72) Erfinder: ELLMER, Klaus, 12683 Berlin (DE); UNOLD, Thomas, 14469 Potsdam (DE)
(74) Vertreter: Rudolph, Margit
(86) Internationale Anmeldenummer: PCT/DE2007/001998
(87) Internationale Veröffentlichungsnummer: WO 2008/064632

(56) Entgegenhaltungen:
- UNOLD T. ; ENZENHOFER T. ; SIEBER I. ; ELLMER K.: "Reactive magnetron sputtering of CuInS2 solar cells - the influence of the deposition conditions on structural and electronic properties and solar cell efficiency." TECHNICAL DIGEST / 15TH INTERNATIONAL PHOTOVOLTAIC SCIENCE AND ENGINEERING CONFERENCE (PVSEC-15), 15. Oktober 2005 (2005-10-15), Seiten 503-504, XP008089616 in der Anmeldung erwähnt
- SHAO L ET AL: "The one-step vacuum growth of high-quality CuInS2 thin film suitable for photovoltaic applications" MATERIALS SCIENCE IN SEMICONDUCTOR PROCESSING, ELSEVIER SCIENCE PUBLISHERS B.V., BARKING, UK, Bd. 6, Nr. 5-6, Oktober 2003 (2003-10), Seiten 397-400, XP004498921 ISSN: 1369-8001

## Beschreibung

Die Erfindung bezieht sich auf ein Verfahren zur großflächigen Abscheidung von Chalkopyrit-Absorberschichten in Dünnschichtsolarzellen auf ein Substrat durch reaktives Magnetron-Sputtern mit zumindest einer Doppel-Magnetronquelle mit zumindest einem ersten Kupfertarget und einem zweiten Target zum Abscheiden von Indium, Gallium oder Aluminium in der Chalkopyrit-Absorberschicht sowie mit einem Inertgas und einem chalkogenhaltigen Reaktivgas im Magnetronplasma mit einer speziellen Kombination unterschiedlicher Verfahrensparametern.

Die Photovoltaikindustrie weist gegenwärtig sehr große Wachstumsraten von 30-40% pro Jahr auf. Dünnschichtsolarzellen haben dabei jedoch nur einen kleinen Marktanteil von ca. 5%, verglichen mit Solarzellen aus kristallinem Silizium. Die Dünnschichttechnologie besitzt jedoch eine Reihe von attraktiven Vorteilen, beispielsweise die Möglichkeit der großflächigen Beschichtung bei niedrigen Kosten, die Beschichtung auf flexiblen Substraten und die mögliche Realisierung kompletter Durchlauf- oder sogar Rolle-zu-Rolle-Solarzellen-Beschichtungsanlagen (Bandbeschichtung). Ein für große zu beschichtende Flächen besonders geeignetes Abscheideverfahren ist das Magnetron-Sputtern. Mit diesem Verfahren werden Architektur- und Wärmedämmgläser mit Abmessungen bis zu 3x6m in der Größenordnung von 50-100 Millionen m²/Jahr beschichtet. In großtechnischer Anwendung wird Magnetron-Sputtern heute vor allem für die Herstellung von Metallschichten (Compact Disc, Mikroelektronik), optischen Schichten (z.B. Entspiegelungen, Wärmedämmschichten), magnetischen Schichten (Festplatten, Leseköpfe), Hartstoffschichten (Werkzeugbeschichtung) und Schutzschichten (SiO₂) eingesetzt. Diese Breite der Anwendungen zeigt, dass das Magnetron-Sputtern auch eine für die großflächige Herstellung von Solarzellen besonders geeignete Abscheidetechnik sein sollte.

### Stand der Technik

Der Aufbau einer Dünnschichtsolarzelle ist vom Prinzip her sehr einfach. Auf einem metallischen Rückkontakt (z.B. Molybdän) wird eine Absorberschicht (z.B. hochabsorbierender Verbindungshalbleiter) als aktive Schicht abgeschieden. Für den Lichteintritt und zur Stromsammlung wird noch ein transparenter Frontkontakt benötigt, der aus einem entarteten, breitbandigen Halbleiter besteht (z.B. Indium-Zinn-Oxid oder Zinkoxid). Meist wird noch eine Pufferschicht zwischen Absorber und Fensterschicht eingefügt, um die Grenzflächeneigenschaften und damit die Leerlaufspannung der Solarzelle zu verbessern. Ein derartig einfacher Schichtaufbau mit Gesamtdicken im Bereich von 2-4 µm sollte für ein Durchlaufbeschichtungsverfahren wie das Magnetron-Sputtern besonders geeignet sein. Während die Metallschicht und die oxidische Fensterschicht bereits heute mittels Magnetron-Sputterns hergestellt werden, hat sich diese Prozesstechnik jedoch für die Absorberschichten bisher nicht durchgesetzt. Zwar gab es immer wieder Versuche im Stand der Technik, hochabsorbierende Verbindungshalbleiter (z.B. CdTe, CuInSe₂, CuInS₂) direkt durch Magnetron-Sputtern abzuscheiden (vergleiche **Veröffentlichung I)** Großflächige und/oder Rolle-zu-Rolle-Prozesse werden erfolgreich angewendet für amorphes Silizium (Uni-Solar). Für die Herstellung der aktiven a-Si:H-Schicht wird die plasmagestützte chemische Gasphasenabscheidung (PECVD) mit Anregungsfrequenzen > 13 MHz bei Substrattemperaturen um 250 °C benutzt.

Jedoch weisen die solcherart mit amorphem Silizium gefertigten Solarzellen wegen der inhärenten, lichtinduzierten Degradation dieses Materials relativ geringe Wirkungsgrade von etwa 6 % auf, verglichen mit Dünnschicht-Solarzellen, die mit thermischen oder Aufdampfprozessen hergestellt wurden. Ein Wirkungsgrad von 10% wird aber von der Industrie als notwendig angesehen, um eine Dünnschicht-Solarzellentechnologie auf dem Markt zu etablieren zu können.

Solarzellen-Wirkungsgrade größer als 10% konnten mit Sputterprozessen bisher nur als Koverdampung, mit Hilfe zusätzlicher Temperschritte bei höheren Temperaturen, entweder in CdCl₄-Atmosphäre im Falle von CdTe-Solarzellen, durch Sulfurisierung bei CuInS₂ oder als Sputterprozess mit anschließender Selenisierung erreicht werden. Die Hochskalierung von Verdampfungs- und Selenisierungsprozessen ist allerdings schwierig und kontinuierliche Rolle-zu-Rolle-Prozesse für diesen Ablauf sind im Stand der Technik nicht bekannt.

Rolle-zu-Rolle-Sputterprozesse unter Verwendung von Verbindungstargets CuSe₂ und InGaSe sind beispielsweise bekannt aus der US6.974.976B2**,** US 2004/0063320A1 und US2005/0109392A1**.** In diesen Schutzrechten werden jedoch nur die Anordnung und/oder die Materialien der Schichten der Solarzelle offenbart. Die Spezifika des Magnetron-Sputterprozesses (Thermalisierung von gesputterten Spezies, Teilchenenergien, chemische Aktivierung) werden nicht behandelt.

CulnS₂-Dünnschichtsolarzellen werden kommerziell gefertigt in einem Prozess, bei dem metallische Precursorschichten gesputtert und anschließend sulfurisiert werden **(**DE100 04 733C2**).** Dieser Prozess ist allerdings nur möglich für eine Cu-reiche Prozessführung, bei der die sich bildenden hochleitfähigen CuₓS-Phasen anschließend in einer hochtoxischen KCN-Lösung abgeätzt werden. Weitere typische Abscheidebedingungen sind Substrattemperaturen von 500 bis 550 °C und ein deutlicher Schwefelüberschuss für die Sulfurisierungsreaktion.

Ein Rolle-zu-Rolle-Prozess ist auch in dieser Prozessführung nicht demonstriert worden. Außerdem ermöglicht dieser sequenzielle Prozess nicht die kontrollierte Erzeugung chemischer Gradienten über die Dicke der Chalkopyrit-Absorberschicht, da beim thermischen Sulfurisieren oder Selenisieren eine komplette Schichtdurchmischung erfolgt, die vorher erzeugte Gradienten wieder beseitigen würde. Experimente zum RF-Sputtern und zum reaktiven Magnetron-Sputtern von CuInS₂ wurden über die letzten 20 Jahre durchgeführt, ohne jedoch eine stabile Prozessführung mit Wirkungsgraden, vergleichbar mit dem von Solarzellen der etablierten Prozesse, zu erreichen (vergleiche **Veröffentlichung 11).** Diese Misserfolge führten zu der allgemein in der Photovoltaikgemeinschaft verbreiteten Meinung, dass das Magnetron-Sputtern zwar für Kontaktschichten (Molybdän bzw. ZnO/ZnO:Al) und für Vorläufer(Precursor)-Schichten (Cu, In) eingesetzt werden kann, jedoch nicht für die Abscheidung der aktiven Schichten, d.h. der Solarzellenabsorber, da diese besonders hohe Anforderungen hinsichtlich der Defektarmut stellen (vergleiche **Veröffentlichung III).**

Beim Einsatz des reaktiven Magnetron-Sputterns für Hartstoff-, Metall- oder optische Schichten ist es Stand der Technik, Substratvorspannungen von -100 bis -300 V relativ zum Plasmapotenzial zu nutzen, um die Ionenunterstützung des Schichtwachstums zu erhöhen. Außerdem werden seit einigen Jahren Hochleistungs-Sputternetzteile eingesetzt, die kurzzeitig Spannungen weit über eintausend Volt an das Magnetron-Sputtertarget anlegen, um hochenergetische Teilchen für das Schichtwachstum bereitzustellen.

In einer Magnetron-Sputter-Entladung ist eine Vielzahl von Ionen und Neutralteilchen mit Energien zwischen einigen bis mehreren Hundert Elektronenvolt (eV) im Plasma vorhanden. Diese Energien sind viel höher als bei einem rein thermischen Abscheideverfahren und als die Defektbildungsenergien in Halbleitern, die üblicherweise im Bereich mehrerer eV liegen. Sie erhöhen die Adatom-Beweglichkeit auf der wachsenden Schicht, wodurch deren Morphologie und kristalline Qualität verbessert wird. Durch den ständigen Teilchenbeschuss der wachsenden Filmoberfläche werden aber auch strukturelle und damit elektronische Defekte in der Schicht erzeugt. Dabei hängt die Zahl der erzeugten Defekte stark vom gewählten Materialsystem und vom Zusammenspiel der gewählten Sputterparameter, wie z.B. Temperatur, Druck und Leistungsdichte, ab. Während bei optischen, metallischen, magnetischen oder Hartstoffschichten eine gut kontrollierte Zusammensetzung, Dickenhomogenität und in manchen Fällen die kristalline Qualität wichtig sind, spielen für photoaktive Halbleiterschichten aber die elektronischen Eigenschaften, insbesondere die Anzahl der elektronischen Defekte, eine entscheidende Rolle. Um in Dünnschichtsolarzellen Wirkungsgrade über 10% zu erreichen, sind Diffusionslängen der photogenerierten Ladungsträger von der Größenordnung der Schichtdicke notwendig, gleichbedeutend mit einer Konzentration der elektronischen Defekte im ppm-Bereich. Andererseits bieten aber plasmagestützte Abscheideverfahren durch die höheren Teilchenenergien und durch das Vorhandensein chemisch reaktiver Komponenten (atomare und angeregte Spezies) die Möglichkeit, Schichten bei wesentlich niedrigeren Substrattemperaturen oder kompaktere Schichten herzustellen, was insbesondere für die Herstellung von Dünnschicht-Solarzellen besonders attraktiv ist. Im Stand der Technik wurde bereits gezeigt, dass das reaktive Magnetron-Sputtern für die Abscheidung hochwertiger CuInS₂-Schichten geeignet ist, wenn die Beschichtungsparameter hinsichtlich der Teilchenenergien beim Schichtwachstum speziell ausgesucht werden. Daraus hergestellte Solarzellen wiesen Wirkungsgrade über 10% auf, die vergleichbar sind mit dem Wirkungsgrad von thermisch prozessierten CuInS₂-Schichten. Im Einzelnen handelt es sich beim Stand der Technik neben der bereits weiter oben erwähnten Veröffentlichung um die Veröffentlichungen IV bis VIII.

Die **Veröffentlichung VI** beschreibt erste Erfolge für Abscheidungen mit geringerem Kupfergehalt, nämlich CuInS₂ bei einem Verhältnis von Cu/In von 1,15 und Temperaturen von 410°C oder 500°C. Für die Cu-reiche Präparationsroute (Cu/In=1,15) wurden Wirkungsgrade über 10% erreicht. Für eine In-reiche Präparation wurden bereits 6% Wirkungsgrad erreicht.

Ziel der Veröffentlichungen I und III bis VIII ist es gewesen, zu zeigen, dass es bei einer geeigneten Wahl des Materialsystems zusammen mit optimierten Sputterbedingung möglich ist, Dünnschichthalbleiter mit guten elektronischen Eigenschaften abzuscheiden. Dies war jedoch bis jetzt auf kupferreiche Abscheidung von CuInS₂ beschränkt, und beruhte auf einer Einstellung der Substrattemperatur > 470°C. Eine Abscheidung von für Solarzellen geeigneten Absorberschichten, die bei Temperaturen unter 470°C abgeschieden werden können und die nicht mit chemischen Schritten nachbehandelt werden müssen, war bis jetzt im Stand der Technik nicht möglich. Dies liegt daran, dass bisher kein Weg gefunden werden konnte, einen Beschuss der wachsenden Schicht durch hochenergetische Teilchen zu verhindern, jedoch gleichzeitig einen geeigneten niederenergetischen Energieeintrag durch die Teilchen zu nutzen, um niedrigere Substrattemperaturen zu ermöglichen. Außerdem war eine Abscheidung kupferarmer Schichten bisher nicht möglich, da die Schwefelatome nicht in hinreichender Anzahl in solche Schichten eingebaut werden konnten.

### Aufgabenstellung

Die **Aufgabe** der vorliegenden Erfindung ist daher darin zu sehen, das Verfahren zur großflächigen Abscheidung von Chalkopyrit-Absorberschichten in Dünnschichtsolarzellen auf ein Substrat durch reaktives Magnetron-Sputtern mit zumindest einer Doppel-Magnetronquelle mit zumindest einem ersten Kupfertarget und einem zweiten Target zum Abscheiden von Indium, Gallium oder Aluminium in der Chalkopyrit-Absorberschicht sowie mit einem Inertgas und einem chalkogenhaltigen Reaktivgas im Magnetronplasma so in seinen Verfahrensparametern einzustellen, dass die Vorteile des Magnetron-Sputterns -niedrige Substrattemperaturen, großflächige Abscheidung, hohe chemische Reaktivität, kompakte Schichten für die direkte Abscheidung von Chalkopyrit-Absorberschichten, genutzt und die Nachteile, insbesondere eine Schädigung der empfindlichen Halbleiterschichten, vermieden werden können Die erfindungsgemäße **Lösung** für diese Aufgabe ist dem Hauptanspruch zu entnehmen. Vorteilhafte Weiterbildungen der Erfindung sind den Unteransprüchen zu entnehmen, die im Folgenden im Zusammenhang mit der Erfindung näher erläutert werden.

Die erfindungsgemäße Parameterkombination ergibt sich aus neuesten, teilweise überraschenden Erkenntnissen der Erfinder, die durch spezifische und detaillierte, ebenfalls von den Erfindern entwickelte Plasmadiagnostik-Verfahren gewonnen wurden und die den Erfindern eine Reihe von bislang nicht bekannten Eigenschaften des chalkogenhaltigen Reaktivgas-Plasmas im Magnetron-Sputterprozess offenbart haben. Es wurden neue Erkenntnisse des Verhaltens des chalkogenhaltigen Reaktivgases, insbesondere von Chalkogenwasserstoff, beispielsweise H₂S, in einem Sputterplasma gewonnen, die bislang nicht bekannt waren. In Folge der speziellen Anregung des chalkogenhaltigen Reaktivgases durch die Doppel-Magnetronquellen unter geeigneter Wahl von Prozessparametern nach der Erfindung kommt es - trotz moderater Substrattemperaturen, beispielsweise 370°C, - zu einer bevorzugten Bildung von kleinen Chalkogenmolekülen, beispielsweise Schwefelmolekülen. Da durch wird es nun erstmals möglich, In-reiche Schichten mittels Magnetron-Sputtern abzuscheiden, ohne dass zusätzliche chemische Schritte in der weiteren Prozesskette nötig sind, um ungebundene Chalkogene, insbesondere einen Schwefelüberschuss, zu entfernen. Durch diese neuen Erkenntnisse war es möglich, die oben beschriebene Aufgabenstellung zu lösen, indem durch bestimmte, geschickt und teilweise überraschend gewählte und kombinierte Prozessparameter die aus dem Stand der Technik bekannten negativen Eigenschaften des Reaktivgas-Plasmas minimiert werden konnten, wobei gleichzeitig die positiven Eigenschaften des Reaktivgas-Plasmas erhalten werden konnten. Die sich daraus ergebende Parameterkombination für den Sputterprozess ist:
- Einlassen des chalkogenhaltigen Reaktivgases direkt am Substrat
- Einstellen des Reaktivgasanteils auf 5 bis 30 % des Inertgasanteils im Magnetronplasma
- Einstellen eines hohen Sputterdrucks zwischen 1 und 2 Pa
- Anlegen einer negativen Vorspannung am Substrat
- zeitlich serielles Anordnen verschiedener erster und zweiter Targets in den Doppel-Magnetronquellen und deren Betreiben mit gleichen Sputterleistungen zur Einstellung von Stöchiometriegradienten
- Anregen des Magnetronplasmas mit hochfrequenter Wechselspannung oberhalb von 6 MHz
- Heizen des Substrats auf eine Temperatur zwischen 350°C und 500°C und
- kupferarme Abscheidung, beispielsweise CuInS₂ mit [In/Cu] >1.

Mit der Erfindung wird erstmals eine Kombination unterschiedlicher Parameter für ein Magnetron-Sputterverfahren angegeben, mit der es möglich ist, defektarme Absorberschichten großflächig in Solarzellen abzuscheiden, die Wirkungsgrade deutlich oberhalb von 10% zeigen. Dabei werden neben den aus den genannten **Veröffentlichungen I und IV bis VIII** bekannten und bereits variierten Parametern Plasmaanregung, Substrattemperatur, Sputterdruck und kupferarme Abscheidung neue Parameter aufgezeigt und in unerwarteter Weise miteinander kombiniert. Bei den neuen Parametern handelt es sich im Einzelnen um:

**Reaktivgasanteil:** Es wird ein Reaktivgasanteil zwischen 5 und 30% des Inertgasanteils eingestellt, um den Anteil negativer Ionen (z. B. S⁻, HS⁻, HS₂⁻) von der Doppel-Magnetronquelle zu minimieren.

**Reaktivgaseinlass:** Es wird das chalkogenhaltige Reaktivgas (z.B. H₂S) direkt am Substrat, vorzugsweise parallel zur Substratoberfläche eingelassen, um die Bildung von negativen Ionen (S⁻-Ionen) am Target, die von der Doppel-Magnetronquelle zum Substrat auf hohe Energien beschleunigt werden, zu vermeiden.

**Substratvorspannung:** Es wird während des Sputtervorgangs eine negative Vorspannung an das Substrat angelegt, um den thermalisierten, aber ionisierten Spezies vor dem Substrat (z.B. Ar⁺, Cu⁺, In⁺, S⁺, Se⁺) eine definierte Zusatzenergie zwischen 20 - 50 eV zu geben. Dadurch können kompakte, defektarme Halbleiterschichten bei niedrigen Substrattemperaturen abgeschieden werden.

### Anordnung/Betrieb der Targets, Alternative 1 ist gemäβ der Erfindung

Alternative 1: es werden zeitlich seriell verschiedene erste und zweite Targets in mehreren Doppel-Magnetronquellen angeordnet und diese mit gleichen Sputterleistungen betrieben
Alternative 2: es werden zeitlich parallel gleiche erste und zweite Targets in einer Doppel-Magnetronquelle angeordnet und diese mit unterschiedlichen Sputterleistungen und damit unterschiedlichen Abscheideraten betrieben. Dadurch werden vertikale Elementgradienten (Ga, In, Cu, Al u.a.) in der abgeschiedenen Schicht erzeugt.

Daneben werden bei der Erfindung noch bekannte Parameter vorteilhaft kombiniert:
**Plasmaanregung:** Es wird eine hochfrequente Plasmaanregung mit mehr als 6 MHz vorgenommen.
**Substrattemperatur:** Es können moderate Substrattemperaturen (bevorzugt unterhalb von 420°C) eingestellt werden, sodass insbesondere auch flexible Polymerfolien, die keine höheren Temperaturen vertragen, als Substrate eingesetzt werden können.
**Sputterdruck:** Es werden vergleichsweise hohe Sputterdrücke (mehr als 1 Pa) verwendet, um die Teilchen und Ionen von der Doppel-Magnetronquelle zu thermalisieren.
**Abscheidung:** Es wird eine kupferarme Abscheidung vorgenommen. Dies ist bei der Herstellung von CuInS₂-Schichten gleichbedeutend mit einer indiumreichen Abscheidung ([In]/[Cu]>1). Dadurch wird die Bildung von überschüssigem CuₓS vermieden, sodass der ansonsten immer notwendige nasschemische Ätzschritt in toxischem KCN zu dessen Entfernung entfallen kann. Wesentlich für die hier beschriebene Erfindung ist, dass die kupferarme Abscheidung nur mit oben definierten und sich überraschend ergebenden Parameterkombinationen zu hochwertigen Solarzellenabsorberschichten führt.

Durch die vorgenannte optimale Kombination der unterschiedlichen, neuen und bekannten Sputter-Parameter können bei der Erfindung die Vorteile des Magnetron-Sputterns - zusätzlicher Energieeintrag - genutzt werden, ohne die möglichen Nachteile - Schädigung der wachsenden Schicht durch Ionenbeschuss - zum Tragen kommen zu lassen. Außerdem wird die hohe chemische Reaktivität des Plasmas genutzt, um die notwendige Chalkogenisierung (z.B. durch Schwefel) der Metalle (z.B. Kupfer und Indium) bei tieferen Temperaturen und ohne den sonst üblichen Kupferüberschuss bei der Schichtabscheidung durchführen zu können. Damit bietet sich, insbesondere für Schwefelchalkogenide, die Möglichkeit, auf den sonst üblichen nasschemischen Ätzschritt zu verzichten, wodurch der Herstellungsprozess für derartige Dünnschicht-Solarzellen wesentlich vereinfacht wird.

Vorteilhaft kann mit dem Verfahren nach der Erfindung ein graduierter Bandlückenübergang von der schmalbandigen Chalkopyrit-Absorberschicht zu einer in der Dünnschichtsolarzelle benachbarten Pufferschicht durch entsprechende Auswahl der Targetmaterialien erzeugt werden. Beispielweise können andere Elemente gesputtert werden (z.B. Aluminium oder Zink) oder auf ein Element verzichtet wird (z.B. Kupfer).

Weiterhin ist bei dem Verfahren nach der Erfindung vorteilhaft auch eine Prozessrückkopplung mittels optischer in situ-Messung, beispielsweise mittels ramanspektroskopischer Phasenanalyse, und den Messwerten entsprechender Variation der Magnetron-Sputterleistung und/oder der Substratvorspannung durchführbar.

### Ausführungsbeispiel

Ausbildungsformen des nach der Erfindung parameteroptimierten Magnetron-Sputterns werden nachfolgend anhand der schematischen Figuren näher erläutert. Dabei zeigt:
- **Figur 1:**: Anordnung der Targets, Substrat und Heizer,
- **Figur 2:**: Reaktivgaseinlass am Substrat,
- **Figur 3:**: Schutzgaseinlass an den Targets und
- **Figur 4:**: Einrichtung einer Vorspannung zwischen Substrat und Masse bzw. Magnetron-Targets

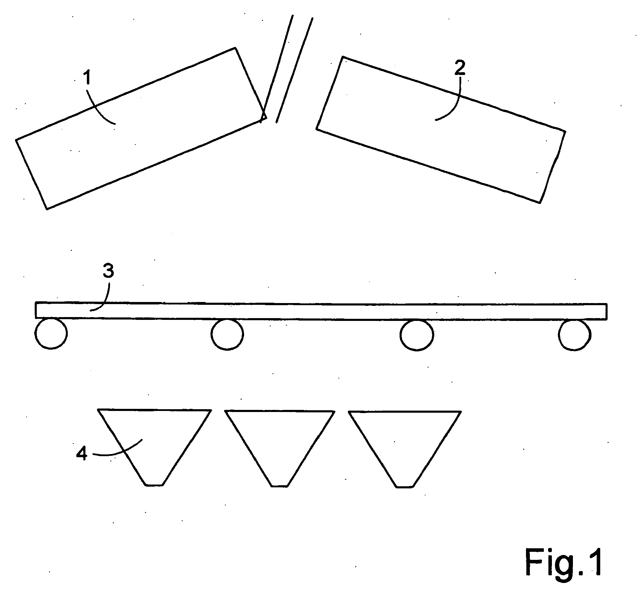

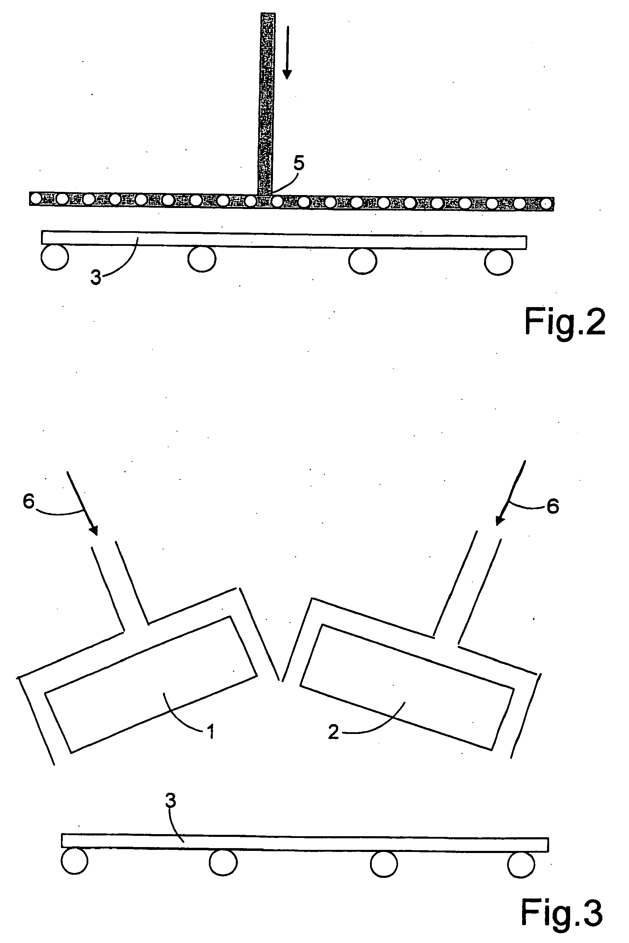

Die Magnetron-Sputteranlage ist mit einer Schleuse versehen, um konstante Prozessbedingungen in der Beschichtungskammer zu gewährleisten. Die Prozesskammer für die Absorberschicht ist mit einer Doppel-Magnetronquelle ausgestattet, die mit einem Kupfer-1 bzw. einem Indium-Target 2 der Reinheit 4N als Sputterquellen bestückt ist. Die Substrate **3** werden unter die Sputterquellen mit den Targets **1, 2** gefahren und während der Beschichtung nicht bewegt **(****Figur 1****).** Alternativ können die Substrate **3** auch unter den Sputterquellen mit den Targets **1, 2** mit langsamer Geschwindigkeit durchgefahren werden. Die Heizung der wachsenden Schicht erfolgt mit Halogenlampen **4** von der Rückseite der Substrate **3.** Der Reaktivgaseinlass **5** erfolgt über eine Gasdusche in der Nähe des Substrates **3 (****Figur 2****).** Der Inertgaseinlass **6** erfolgt direkt an den Sputterquellen mit den Targets **1, 2 (****Figur 3****).**

Der Ablauf des Prozesses für ein Ausführungsbeispiel ist im Einzelnen wie folgt:
(1) Beschichtung des Substrats mit Molybdän als Rückkontakt, danach Einschleusen des Substrats in die Sputterkammer. Die Beschichtung mit Molybdän kann in einer DC-Sputteranlage erfolgen oder auch mit Hilfe einer Elektronenstrahlverdampferquelle.
(2) Aufheizen des Substrats auf 300 °C. Beschichtung des Substrats mit In+Cu in H₂S+Ar (Reaktivgas/Inertgas) bei einem Sputterdruck von 1 Pa und einem H₂S-Partialdruck von 0,3 Pa. Hierbei ist das Verhältnis der Sputterraten Cu/In = 0,85. Die Dicke der erzeugten ersten Schicht beträgt ca. 2 µm.
(2a) Alternativ: Aufheizen des Substrats auf 300 °C. Beschichtung des Substrats mit Indium +Gallium + Kupfer in H₂S+Ar bei einem Sputterdruck von 1 Pa und einem H₂S Partialdruck von 0,28 Pa, Verhältnis der Sputterraten Cu/In = 0,85 und In/Ga = 0,85. Die Dicke der erzeugten ersten Schicht beträgt ebenfalls ca. 2 µm.
(3) Aufheizen des Substrats auf 420 °C, gleichzeitige Beschichtung des Substrats mit In+Cu in H₂S+Ar bei einem Druck von 1 Pa, einem H₂S Partialdruck von 0,3Pa und einem Sputterraten-Verhältnis von Cu/In=1. Die Dicke der erzeugten zweiten Schicht beträgt ca. 1 µm. Dieser Schritt dient dazu, die erste erzeugte Schicht zu rekristallisieren und die endgültige Elementzusammensetzung einzustellen. In dieser Prozessphase wird eine negative Substratvorspannung von 40V angelegt **(Figur 4),** um große Kristallite zu erzeugen, obwohl eine niedrige Substrattemperatur von 420°C herrscht. Der Endpunkt für diesen Prozessschritt wird über Laserlichtstreuung und Pyrometrie bestimmt.
(3a) Alternativ: Aufheizen des Substrats auf 500 °C, gleichzeitige Beschichtung des Substrats mit In+Cu in H₂S+Ar bei einem Druck von 1 Pa und einem Sputterraten-Verhältnis von Cu/In= 1,2. Die Dicke der erzeugten zweiten Schicht beträgt ebenfalls ca. 1 µm. In dieser Phase wird mit KupferÜberschuss abgeschieden, um eine stöchiometrische Schichtzusammensetzung zu erreichen. Für diesen alternativen Prozessschritt kann auf eine negative Substratvorspannung verzichtet werden. Der Prozessendpunkt wird mit Hilfe von Laserlichtstreuung und Pyrometrie bestimmt.
(4) Abscheidung einer ca. 50 nm dicken Pufferschicht durch Magnetron-Sputtern von In₂S₃ oder Zn(O, S).
(4a) Alternativ: Chemische Badabscheidung einer 50 nm dicken CdS-Schicht als Pufferschicht.
(4b) Alternativ: An der Oberfläche segregierte CuₓS-Phasen werden über einen KCN- Ätzschritt entfernt. Danach chemische Badabscheidung einer 50nm dicken CdS Schicht als Pufferschicht.
(4c) Alternativ: An der Oberfläche segregierte CuₓS-Phasen werden über einen KCN- Ätzschritt entfernt. Danach Abscheidung einer 50nm dicken Pufferschicht durch Magnetron-Sputtern von In₂S₃ oder Zn(O, S).
(5) Magnetron-Sputtern einer ca. 1 µm dicken ZnO/ZnO:Al-Schicht als Frontkontakt.

Die Implementierung der Verfahrensschritte (1, 2, 2a, 3, 3a, 4, 5) beschreibt einen Herstellungsprozess für eine CuInS₂-Solarzelle für Temperaturen unter 500°C mit Hilfe von Magnetron-Sputterprozessen und vorteilhaft ohne chemische Prozessschritte. Die Implementierung der Verfahrensschritte (1, 2, 2a, 3, 3a, 4a-4c, 5) beschreibt den Herstellungsprozess für eine CuInS₂-Solarzelle, der zwei chemische Prozessschritte einschließt.

### Zitierte Veröffentlichungen:

- **Veröffentlichung I:** K. Ellmer, J. Hinze, J. Klaer: "Copper indium disulfide solar cell absorbers prepared in a one-step process by reactive magnetron sputtering from copper and indium targets" Thin Solid Films 413,92,2002
- **Veröffentlichung II:** J. Thornton, T. Lommasson: "Magnetron Reactive Sputtering of Copper-Indium-Selenide", Solar Cells, 16 (1986), pp 165-180
- **Veröffentlichung III:** A.Romeo, M. Terheggen, D. Abou-Ras, D.L. Bätzner, F.-J. Haug, M. Kälin, D. Rudmann, A.N. Tiwari, "Development of thin-film Cu(In,Ga)Se2 and CdTe solar cells", Prog. Photovolt: Res. Appl. 12, pp 93-111 (2004).
- **Veröffentlichung IV:** T. Unold, J. Hinze, K. Ellmer: "CuInS2 Absorber Layers and Solar Cells Deposited by Reactive Magnetron Sputtering from Metallic Targets", Paris, France, 7-11 June, 2004 (WIP-Munich and ETA-Florence), pp 1917-1920
- **Veröffentlichung V:** T. Unold, T. Enzenhofer, K. Ellmer: "Optical, Structural and Electronics Porperties of CuInS2 Solar Cells Deposited by Reactive Magnetron Sputtering", Mat. Res. Soc. Symp. Proc. 865, F16.5.1- 16.5.6 (2005)
- **Veröffentlichung VI:** T. Unold, T. Enzenhofer, I. Sieber, K. Ellmer: "Reactive Magnetron Sputtering of CuInS2 Solar Cells - The Influence of the Deposition Conditions on Structural and Electronic Properties and Solar Cell Efficiency", PVSEC-15, Shanghai, China, October 10-15, 2005, Shanghai Sci. Techn. Publ., pp 503-504
- **Veröffentlichung VII:** T. Unold, I. Sieber, and K. Ellmer: "Efficient CuInS2 solar cells by reactive magnetron sputtering", Appl. Phys. Lett. 88, 213502-1...3 (2006)
- **Veröffentlichung VIII:** K. Ellmer, T. Unold: "Reaktives Magnetronsputtern von Dünnschichtsolarzellen", Vakuum in Forschung und Praxis 18 (September 2006), Nr. 5, pp 6-10

### Bezugszeichenliste

- 1: Kupfertarget (erste Sputterquelle)
- 2: Indiumtarget (zweite Sputterquelle)
- 3: Substrat
- 4: Halogenlampe
- 5: Reaktivgaseinlass
- 6: Inertgaseinlass

## Patentansprüche

1. Verfahren zur großflächigen Abscheidung von Chalkopyrit-Absorberschichten für Dünnschichtsolarzellen auf ein Substrat (3) durch reaktives Magnetron-Sputtern mit zumindest einer Doppel-Magnetronquelle mit zumindest einem ersten Kupfertarget (1) und einem zweiten Target (2) zum Abscheiden von Indium, Gallium oder Aluminium in der Chalkopyrit-Absorberschicht sowie mit einem Inertgas und einem chalkogenhaltigen Reaktivgas im Magnetronplasma mit den Verfahrensparametern:
• Einlassen (5) des chalkogenhaltigen Reaktivgases direkt am Substrat (3)
• Einstellen des chalkogenhaltigen Reaktivgasanteils auf 5 bis 30 % des Inertgasanteils im Magnetronplasma
• Einstellen eines hohen Sputterdrucks zwischen 1 und 2 Pa
• Anlegen einer negativen Vorspannung am Substrat (3)
• zeitlich serielles Anordnen verschiedener erster und zweiter Targets (1, 2) in den Doppel-Magnetronquellen und deren Betreiben mit gleichen Sputterleistungen zur Einstellung von Stöchiometriegradienten
• Anregen des Magnetronplasmas mit hochfrequenter Wechselspannung oberhalb von 6 MHz
• Heizen des Substrats (3) auf eine Temperatur zwischen 350°C und 500°C und
• kupferarme Abscheidung, beispielsweise CuInS₂ mit [In/Cu] >1.

2. Verfahren nach Anspruch 1,
**gekennzeichnet durch**
• direktes Einlassen (5) des chalkogenhaltigen Reaktivgases parallel zur Oberfläche des Substrats (3).

3. Verfahren nach Anspruch 1 oder 2,
**gekennzeichnet durch**
das Entfallen zusätzlicher chemischer Schritte im Verfahrensablauf.

4. Verfahren nach einem der Ansprüche 1 bis 3,
**gekennzeichnet durch**
die Erzeugung eines graduierten Bandlückenübergangs von der schmalbandigen Chalkopyrit-Absorberschicht zu einer in der Dünnschichtsolarzelle benachbarten Pufferschicht **durch** entsprechende Auswahl der Targetmaterialien.

5. Verfahren nach einem der Ansprüche 1 bis 4,
**gekennzeichnet durch**
CuInS₂ als abzuscheidendes Chalkopyrit, Argon als Inertgas, H₂S als chalkogenhaltigem Reaktivgas, Indium als zweites Target (2) in der Doppel-Magnetronquelle, wobei ein Verhältnis [In]/[Cu] >1 eingestellt wird.

6. Verfahren nach einem der Ansprüche 1 bis 4,
**gekennzeichnet durch**
CuInSe₂ als abzuscheidendes Chalkopyrit, Argon als Inertgas, H₂Se als chalkogenhaltigem Reaktivgas, Indium als zweites Target (2) in der Doppel-Magnetronquelle, wobei ein Verhältnis [In]/[Cu] >1 eingestellt wird.

7. Verfahren nach einem der Ansprüche 1 bis 6,
**gekennzeichnet durch**
eine Prozessrückkopplung mittels optischer in situ-Messung, insbesondere durch ramanspektroskopische Phasenanalyse, und den Messwerten entsprechender Variation der Magnetron-Sputterleistung und/oder der Substratvorspannung.

## Claims

1. A method for the large-scale deposition of chalcopyrite absorber layers for thin-film solar cells on a substrate (3) by reactive magnetron sputtering using at least one double magnetron source with at least a first copper target (1) and a second target (2) for the deposition of indium, gallium or aluminium in the chalcopyrite absorber layer and using an inert gas and a chalcogen-containing reactive gas in the magnetron plasma, comprising the following method parameters:
• admitting (5) the chalcogen-containing reactive gas directly at the substrate (3)
• setting the chalcogen-containing reactive gas fraction to 5 to 30 % of the inert gas fraction in the magnetron plasma
• setting a high sputtering pressure between 1 and 2 Pa
• applying a negative bias voltage to the substrate (3)
• arranging different first and second targets (1, 2) in the double magnetron sources in a temporal sequence and operating them with identical sputtering powers to set stoichiometry gradients
• exciting the magnetron plasma with a highfrequency alternating voltage above 6 MHz
• heating the substrate (3) to a temperature between 350 °C and 500 °C, and
• low-copper deposition, for example CuInS₂ with [In/Cu] > 1.

2. The method according to claim 1,
**characterised by**
• direct admission (5) of the chalcogen-containing reactive gas parallel to the surface of the substrate (3).

3. The method according to either claim 1 or claim 2,
**characterised by**
the omission of additional chemical steps over the course of the method.

4. The method according to any one of claims 1 to 3,
**characterised by**
the generation of a graduated band gap transition from the narrow-band chalcopyrite absorber layer to an adjacent buffer layer in the thin-film solar cell by appropriate selection of the target materials.

5. The method according to any one of claims 1 to 4,
**characterised by**
CuInS₂ as the chalcopyrite to be deposited, argon as the inert gas, H₂S as the chalcogen-containing reactive gas, and indium as the second target (2) in the double magnetron source, a ratio [In]/[Cu] of > 1 being set.

6. The method according to any one of claims 1 to 4,
**characterised by**
CuInSe₂ as the chalcopyrite to be deposited, argon as the inert gas, H₂Se as the chalcogen-containing reactive gas, and indium as the second target (2) in the double magnetron source, a ratio [In]/[Cu] of >1 being set.

7. The method according to any one of claims 1 to 6,
**characterised by**
a process feedback by means of optical *in situ* measurement, in particular by Raman spectroscopic phase analysis; and variation of the magnetron sputtering power and/or of the substrate bias voltage in accordance with the measured values.

## Revendications

1. Procédé destiné à déposer sur un substrat (3) de grande étendue des couches absorbantes en chalcopyrite pour ainsi réaliser des cellules solaires à couches minces, le dépôt étant réalisé par pulvérisation cathodique magnétron avec au moins une source à double magnétron pourvue d'au moins une première cible en cuivre (1) et d'une deuxième cible (2) servant à déposer de l'indium, du gallium ou de l'aluminium au sein de la couche absorbante en chalkopyrite ainsi qu'avec un gaz inerte et un gaz réactif contenant des chalcogènes au sein du plasma de magnétron, ledit procédé ayant les paramètres suivants :
• introduction (5) dudit gaz réactif contenant des chalcogènes, directement au niveau du substrat (3)
• ajustement de la proportion du gaz réactif contenant des chalcogènes, de façon à qu'il représente 5 à 30 % de la proportion du gaz inerte au sein du plasma de magnetron
• mise en oeuvre d'une pression élevée de pulvérisation cathodique, comprise en 1 et 2 Pa
• mise en oeuvre d'une tension préalable négative au niveau du substrat (3)
• disposition, l'une après l'autre dans le temps, des première et deuxième cibles (1, 2) qui sont de nature différente, au sein desdites sources à double magnétron et mise en oeuvre de ces dernières avec des puissances de pulvérisation cathodiques égales pour ainsi établir des gradients de stoechiométrie
• excitation du plasma de magnetron au moyen d'une tension alternative de haute fréquence, supérieure à 6 MHz
• chauffage du substrat (3) à une température comprise entre 350 °C et 500 °C et
• dépôt pauvre en cuivre, par exemple de CuInS₂, avec [In/Cu] > 1.

2. Procédé selon la revendication 1,
**caractérisé par**
• une introduction (5) directe dudit gaz réactif contenant des chalcogènes, parallèlement à la surface du substrat (3).

3. Procédé selon les revendications 1 ou 2,
**caractérisé par**
l'absence d'étapes chimiques supplémentaires au cours dudit procédé.

4. Procédé selon l'une des revendications 1 à 3,
**caractérisé par**
la génération d'une jonction graduelle à travers le gap entre ladite couche absorbante en chalcopyrite présentant une bande étroite et une couche tampon adjacente au sein de ladite cellule solaire à couches minces, au moyen d'un choix pertinent des matériaux cibles.

5. Procédé selon l'une des revendications 1 à 4,
**caractérisé par**
le CuInS₂ en tant que chalcopyrite à déposer, l'argon en tant que gaz inerte, le H₂S en tant que gaz réactif contenant des chalcogènes, l'indium en tant que deuxième cible (2) au sein de ladite source à double magnétron, le rapport [In]/[Cu] étant ajusté de façon à ce qu'il soit 1.

6. Procédé selon l'une des revendications 1 à 4,
**caractérisé par**
le CuInSe₂ en tant que chalcopyrite à déposer, l'argon en tant que gaz inerte, le H₂Se en tant que gaz réactif contenant des chalcogènes, l'indium en tant que deuxième cible (2) au sein de ladite source à double magnétron, le rapport [In]/[Cu] étant ajusté de façon à ce qu'il soit > 1.

7. Procédé selon l'une des revendications 1 à 6,
**caractérisé par**
un processus rétroactif mis en oeuvre au moyen d'une mesure optique in-situ, s'agissant notamment d'une analyse de phase par spectroskopie Raman, et d'une variation de la puissance de pulvérisation cathodique magnétron et/ou de la tension préalable du substrat en fonction des résultats de ladite mesure.
